# EUROPEAN PATENT SPECIFICATION

(11) **EP 0 691 704 B1**
(45) Date of publication and mention of the grant of the patent: **03.11.1999**
(21) Application number: 94830339.1
(22) Date of filing: 07.07.1994
(51) Int. Cl.: H01R 23/66, H01R 13/631, H05K 7/14

(54) **A connector holder with spatial adjustment of the connector position**
Verbinderhalter mit räumlicher Einstellung der Lage des Verbinders
Porte-connecteur avec ajustement spatial de la position du connecteur

(43) Date of publication of application: 10.01.1996
(73) Proprietor: Bull HN Information Systems Italia S.p.A., 20010 Pregnana Milanese (Milano) (IT)
(72) Inventor: Spagna, Danilo, I-20017 RHO (Milano) (IT)
(74) Representative: Pezzoli, Ennio

(56) References cited:
- DE-A- 3 814 092
- FR-A- 2 127 328
- US-A- 3 433 909
- US-A- 3 596 018
- US-A- 4 580 858
- US-A- 5 295 839

## Description

This invention relates to interconnection systems for electronic apparatus, particularly printed circuit boards in data processing systems.

As is known, data processing systems comprise a plurality of printed circuit boards, usually arranged side-by-side and parallel with one another and interconnected by a transverse printed circuit board commonly referred to as the back panel.

A number of male or female connectors are mounted to the back panel which have several terminals and are intended for coupling to corresponding female or male connectors, each mounted to a printed circuit board.

The printed circuit boards are fitted onto a rack having guide rails which enable boards to be removed or inserted in a guided fashion, and their respective connectors to be coupled to corresponding back panel connectors.

A trend toward increased miniaturization has led to the introduction of connectors having a large number, in the 100 to 200 range, of connection terminals clustered very close to one another (typically at a spacing between terminals on the order of 0.6 mm), which involve guided precision coupling of the male/female connectors and cannot rely for it on the relative accuracy of the back panel fit to the PC board guide rails.

To ensure accurate alignment of the connectors, it has been suggested of equipping the back panel and the printed circuit boards with alignment pins for co-operation with mating registry sockets.

US-A-4 580 858 discloses a connector system for connecting respective connectors of two PCBS together, there being provided means for guiding the connectors into alignment.

This prior approach has shown to be inadequate for the amount of miniaturization presently afforded by connectors of the "Micropax" (Registered Trademark) type.

It is indeed a recognized fact that printed circuit boards, especially large ones, cannot be supplied in a truly flat state, as a consequence of the processing and component welding steps involved in their manufacture.

Accordingly, they require the provision of guide rails which allow for an amount of play, so that the aligning feature of the pins can lead to added warping of the boards and consequent parallelism error in the connector coupling, angular deviation from the nominal line of insertion,improper electrical connection, and mechanical straining of the connectors.

In addition, they do not lend themselves for direct jumper connections, using flexible flat cables, between printed circuit boards having connectors placed in positions only partly within or altogether out of the operator's reach.

In fact, elaborate data processing systems may also require, additionally to connections to the back panel, that direct connections be made between removable boards, and the board layout may provide for combinations of mutually parallel boards with perpendicularly arranged ones.

In such circumstances, the interconnection of boards outside of their sockets, and the joint insertion or removal of boards interconnected by their sockets, are not viable.

And besides, in such cases as when two boards placed within separate adjacent cabinets are to be connected electrically, the operations may be altogether impossible to complete because the connecting cable would have to be passed through small size openings in the cabinets.

This requires that at least one end of the cable be freed from the obstacle represented by its connection to a board.

A further limitation is brought about by the need for using interconnection cables of very short length to minimize the signals propagation times, which involves of necessity that the connectors be located out of the operator's reach in order for the connector coupling to take place in an accurate and reliable manner.

A further problem is represented by the need to apply a controlled connector inserting force and ensure insertion to an accurately predetermined depth.

### SUMMARY OF THE INVENTION

All these requirements are met by the connector holder with spatial connector position adjustment of this invention as defined in claim 1.

The supporting element may be attached, either permanently or releasably, to the back panel or another fixed element of the electronic apparatus in a suitable position to allow the connector to be coupled to a corresponding PC board connector as the board is inserted into its socket in a guided fashion.

The coupling accuracy is ensured by the spatial position of the connector being made adjustable through the various degrees of freedom.

According to a further embodiment of this invention, the attachment of the supporting element to the back panel is releasable and accomplished by the supporting element being a bayonet fit into a base made fast with the back panel.

The insertion is performed by a first movement in the connector direction of insertion, and a second movement in a perpendicular direction to the former.

The mutual positions of the base and the supporting element in the inserted condition are secured by means of screw fasteners located in an easily accessed position and tightened manually or with standard tooling.

Upon completion of the insertion, the forces due to coupling of the corresponding board connector are transferred to the base without straining the fasteners and impairing their holding power which only serves to prevent relative movement of the base and the supporting element.

### BRIEF DECSRIPTION OF THE DRAWINGS

The features and advantages of the invention will become apparent from the following description of a preferred embodiment of the invention, given with reference to the accompanying drawings, in which:
Figure 1 is an exploded perspective view of a preferred embodiment of a connector holder with spatial position adjustment;
Figure 2 is a perspective view of an exemplary application of the connector holder in Figure 1;
Figure 3 is a perspective view of a first variation of elements of the holder in Figure 1;
Figure 4 is a perspective view of a second variation of elements of the holder in Figure 1.

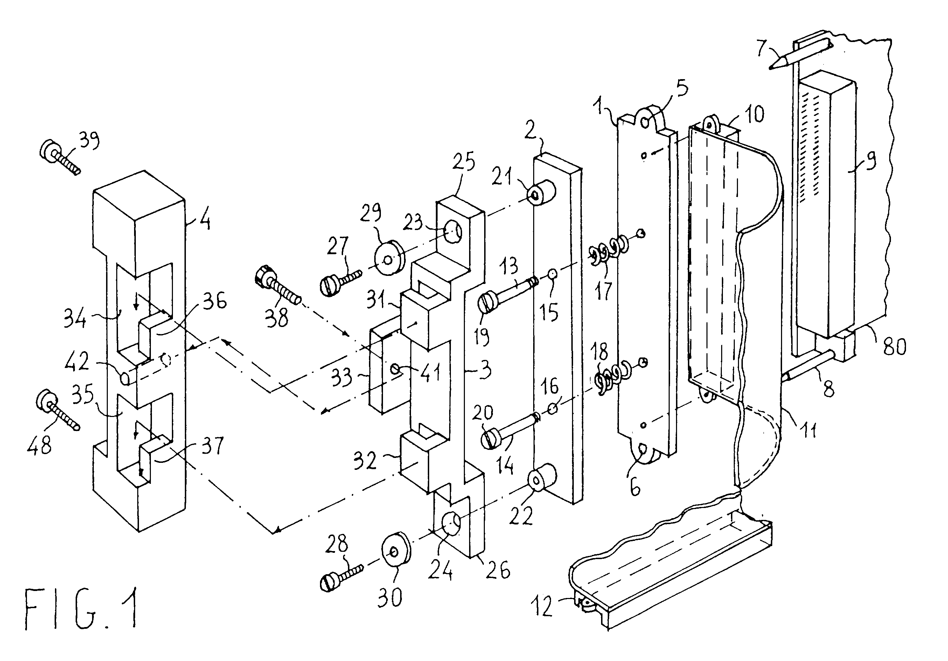

With reference to Figure 1, the connector holder with spatial position adjustment comprises a first supporting plate 1, second supporting plate 2, supporting element 3, and mounting base 4.

The plate 1 has a generally rectangular shape and has two calibrated cylindrical alignment sockets 5, 6 on its end adapted to receive two alignment pins 7, 8 respectively rigid with a printed circuit board 80 having a connector 9 for printed circuit boards with one- or two-line contact.

Fastened to one face of the plate 1 by means of screws is a connector 10 intended for coupling to the connector 9 and having a flexible ribbon cable 11 welded thereto which is terminated with a second connector 12.

The connectors 9 and 10 are positioned in an accurate permanent way relative to the pins 7, 8 and the sockets 5, 6 such that the insertion of the alignment pins into the sockets will ensure coaxial alignment of the two connectors.

The plate 1 is made fast with the plate 2, also generally rectangular in shape, by means of guide pins 13, 14 threaded perpendicularly into the plate 1 at the midsection of the connector 10 in the direction of its length and fitting slidably into two cylindrical housings 15, 16 in the plate 2.

Two compression coil springs 17, 18 are wound around the pins 12, 14 between the two plates 1 and 2.

The pins 13, 14 are terminated with two retainer heads 19, 20 which prevent the plate 2 from slipping off the pins and ensure a predetermined spring loading directed to hold the two plates 1 and 2 parallel with and spaced apart from each other.

By appropriate selection of the pin-to-housing clearance and the thickness of the plate 2, the maximum deviation from relative parallelism of the two plates and variation in relative rotation about a parallel axis to the direction of elongation of the plates and the connectors can be set.

The plate 2 has two cylindrical turrets 21, 22 of predetermined height which respectively fit with a predetermined clearance into two cylindrical openings 23, 24 in the supporting element 3.

The element 3 is preferably a die-casting comprising a U-shaped bracket ending in two flanges 25, 26 whose thickness is equal to the height of the turrets 21, 22 and in which the openings 23, 24 are formed.

Two screws 27, 28 with lockwashers 29, 30 are threaded into corresponding sockets in the turrets 21, 22 and fasten in an unreleasable manner the supporting element 3 to the plate 2 leaving a predetermined clearance across the mating plane.

The supporting element 3 may be provided with permanent or releasable means of fastening to a mechanical support such as a back panel or a frame.

Expediently, as shown in Figure 1, the supporting element 3 has hook-on teeth 31, 32 opposite to a retainer flange 33 to form a releasable bayonet fit into a base 4, in turn attached to a back panel or a frame by means of screws 39 and 40 or any equivalent arrangement.

The base 4 has the general form of an elongate right parallelepipedon and has two fitting sockets 34, 35 complementary in shape of the teeth 31, 32 and provided with retainer teeth 36, 37.

The hook-on teeth 31, 32 of the supporting element 3 fit into the sockets 34, 36 as the elements 3 and 4 are brought near in the perpendicular direction to the plane of the plates 1 and 2. The opposed arrangement of the retainer flange 33 and the teeth 31, 32 ensures that the base 4 and the supporting element 3 will interfit with freedom of relative translation parallel with the plane of the plates 1, 2 and along their direction of greater length.

By relative translation in this direction, the teeth 31 and 32 are caused to engage with the teeth 36, 37 and prevent the two elements from coming apart.

The two elements are also held in place by a screw 38, preferably a captive thumbscrew for manual screwing passed through a socket 41 formed in the flange 33 and engaged in a threaded socket 42 formed in the base 4.

Clearly the connector 12 may also be provided with a spatially adjustable holder as described.

The functional features of the connector holder described are self-evident.

As a printed circuit board complete with alignment pins 7, 8 and connector 9 is pushed, in a guided fashion along suitable rack rails, toward the connector 10, attached to a back panel or frame with the intermediary of the holder, the tapered end pins 7, 8 fit into the sockets 5 and 6 and align axially the aggregate including the connector 10 and plates 1 and 2 which is adapted to be translated relative to the supporting element 3 in the perpendicular plane of the plates to the direction of insertion.

On the alignment being achieved, the connector 9 will be properly coupled to the connector 10.

Any parallelism errors between the connectors 9 and 10 are taken up by the compliance of the elastic bond formed between the plates 1 and 2 and the fitting tolerances between the pins 13, 14 and the sockets 15, 16.

Also, any tolerance in the depth of the printed circuit board, and hence in the depth of insertion, would be absorbed by the compliance of the plate 1 relative to the plate 2 along the direction of insertion.

The thrust applied by the springs 17, 18 ensures that a predetermined, gradually higher insertion force is applied in coupling the two connectors together and the compliance of the plate 1 relative to the plate 2 ensures that the insertion force does not exceed an acceptable maximum value imposed by the elastic constant of the spring for the maximum foreseeable compression condition.

Thus, an accurate and optimum coupling is achieved between a removable electronic board 80 and other fixed or removable electric apparatus, with very short electrical connections arranged in positions out of the operator's reach for reliable coupling of the connectors.

It should also be noted that the holder described has a further important advantage in that it ensures that during removal of the board 80 from its socket, the connector 10 cannot be entrained frictionally along with the plate but becomes disconnected from the connector 9 while staying fast with its support.

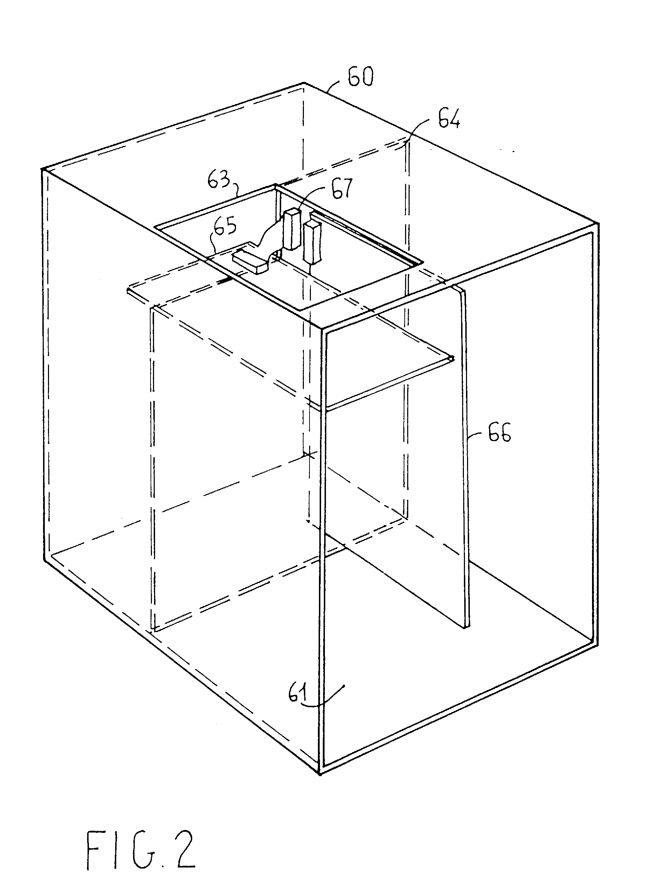

Figure 2 shows by way of example a typical application wherein the holder described is employed to advantage.

In Figure 2, a data processing system comprises a plurality of electronic apparatus housed within a cabinet 60 which allows the apparatus to be accessed from the front 61, the rear, and through an upper opening 63.

Housed within the cabinet, at an intermediate location to the front and rear, is a back panel 64 which carries a mother board 65 which is arranged parallel with the top face of the cabinet and facing the upper opening 63.

Engaged by connectors with the mother board 65 are daughter boards arranged vertically and not shown in the drawing for clarity.

These boards can be inserted and removed through the top opening 63.

Through the front 61, printed circuit boards arranged vertically, only one 66 of which is shown, are inserted or removed from the cabinet.

A need exists for having the board 65 connected to the board 66 while ensuring unrestricted removability for the board 66.

To this aim, a connector holder 67 of the kind described above is attached to the back panel 64 such that upon insertion of the board 66 into its housing, a connector of the board 66 will become coupled to the connector attached to the holder.

The flexible ribbon cable of the holder will then make the connection to the mother board 65.

The foregoing description only covers a preferred embodiment and many changes may be made thereunto. In particular, where required for access or installation reasons, the supporting element 3 may be provided with means for fastening it to the base 4 which are operable from one end or the front rather than from one side of the base 4 as shown.

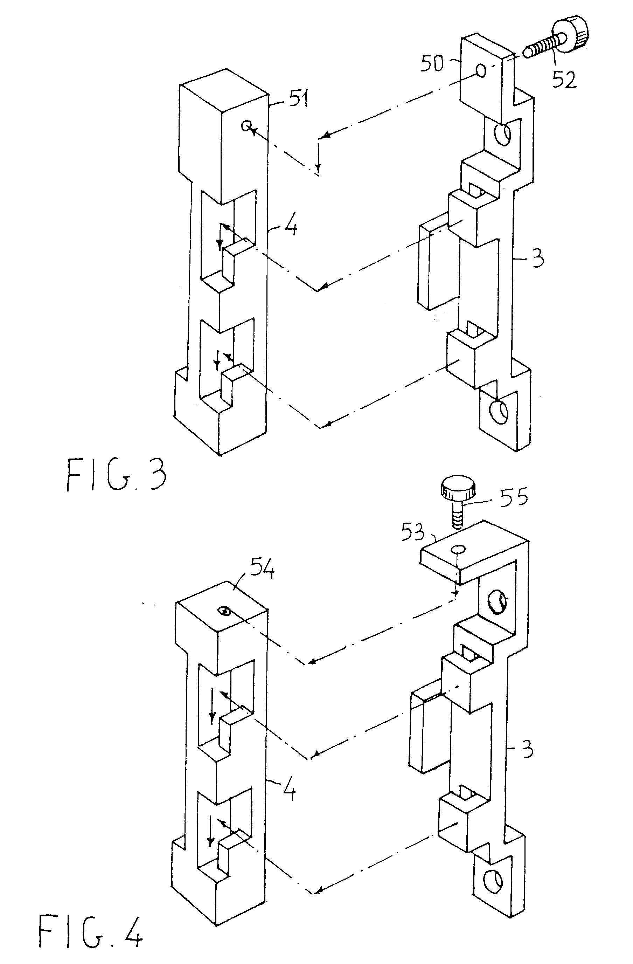

For example, as shown in Figure 3, the element 3 may be provided with an end flange 50 for coupling to the upper front portion 51 of the base 4 with the element 3 engaged in the base 4.

A screw 52 passed through the flange 50 with an axis oriented in the same direction as the connector direction of insertion is threaded into the base 4 and holds the two elements 3 and 4 in the relative engaged position.

Likewise, as shown in Figure 4, the element 3 may be provided with a wing 53 to overlap the head 54 of the base 4 where it would be retained by a screw 55 operable along the direction of greater length of the base 4.

Clearly other variations may be developed to fill specific demands for accessibility.

In addition, as mentioned above, the supporting element 3, having no teeth 31, 32 and wing 33 in this case, may be attached directly to the back panel or the frame.

Finally, the plate 1 is preferably provided with sockets 5 and 6 for alignment pins, but it would be possible to provide a plate 1 with alignment pins or even with a combination of one alignment pin and socket.

It is also apparent that the printed circuit board 80 to be connected may generally consist of some other type of electric apparatus equipped with a connector and alignment means.

## Claims

1. A connector (10) holder (1,2,3) with spatial adjustment of the connector (10) position comprising:
a first supporting plate (1) lying on a plane,
a first connector (10) affixed to said first plate (1), said first plate being provided with alignment means (5,6) co-operating with alignment means (7,8) on a first electric apparatus (80) to be connected to said first connector (10) along a predetermined direction of insertion perpendicular to the plane of said first plate,
a second supporting plate (2) parallel with said first plate,
first mechanical coupling means (13,14) for coupling said first and second plates together and allowing a predetermined amount of relative movement of said first and second plates in said predetermined direction of insertion and variation in the parallelism of said first and second plates,
elastic means (17,18) for exerting a predetermined separating force between said first and second plates,
a supporting element (3),
second mechanical coupling means (27,28,29,30,21,22) for coupling said second plate (2) to said supporting element (3), thereby providing a predetermined amount of relative mobility in the plane of said second plate (2), and
fastening means (31,32) for fastening said supporting element (3) to a supporting member (4), and
a flexible electrical connection (11) connected electrically to said first connector (10) for connection to a second electric apparatus.

2. A holder as in Claim 1, wherein said first mechanical coupling means comprise a pair of pins (13,14) perpendicular to the plane of said first and second plates, rigid with said first plate and slidably passed through openings (15,16) in said second plate (2), and wherein said elastic means comprise a pair of compression coil springs (17,18) each wound around a pin (13,14) of said pair and interposed between said first and second plates.

3. A holder as in either Claim 1 or 2, wherein said fastening means comprise hook-on teeth (31,32) for interfit with said supporting element and sockets (34,35) for said hook-on teeth in a base (4) of said supporting member.

## Patentansprüche

1. Eine Halterung (1, 2, 3) für einen Verbinder (10) mit einer räumlichen Einstellung der Position des Verbinders (10), mit folgenden Merkmalen:
einer ersten Trageplatte (1), die auf einer Ebene liegt;
einem ersten Verbinder (10), der an der ersten Platte (1) befestigt ist, wobei die erste Platte mit einer Ausrichtungseinrichtung (5, 6) versehen ist, die mit einer Ausrichtungseinrichtung (7, 8) auf einer ersten elektrischen Vorrichtung (80) zusammenwirkt, um mit dem ersten Verbinder (10) entlang einer vorbestimmten Einfügungsrichtung, die senkrecht zu der Ebene der ersten Platte ist, verbunden zu werden,
einer zweiten Trageplatte (2), die parallel zu der ersten Platte ist;
einer ersten mechanischen Kopplungseinrichtung (13, 14) zum Miteinanderkoppeln der ersten und zweiten Platte und zum Ermöglichen eines vorbestimmten Ausmaßes einer Relativbewegung der ersten und zweiten Platte in der vorbestimmten Einfügungsrichtung und einer Variation der parallelen Anordnung der ersten und zweiten Platte;
einer elastischen Einrichtung (17, 18) zum Ausüben einer vorbestimmten Trennungskraft zwischen der ersten und zweiten Platte;
einem Trageelement (3),
einer zweiten mechanischen Kopplungseinrichtung (27, 28, 29, 30, 21, 22) zum Koppeln der zweiten Platte (2) mit dem Trageelement (3), um dadurch ein vorbestimmtes Ausmaß einer Relativbeweglichkeit in der Ebene der zweiten Platte (2) vorzusehen, und
einer Befestigungseinrichtung (31, 32) zum Befestigen des Trageelements (3) an einem Tragebauglied (4), und
einer flexiblen elektrischen Verbindung (11), die elektrisch mit dem ersten Verbinder (10) zur Verbindung mit einer zweiten elektrischen Vorrichtung verbunden ist.

2. Eine Halterung gemäß Anspruch 1, bei der die erste mechanische Kopplungseinrichtung ein Paar von Stiften (13, 14) aufweist, die senkrecht zu der Ebene der ersten und zweiten Platte sind, die starr bezüglich der ersten Platte sind und verschiebbar durch Öffnungen (15, 16) in der zweiten Platte (2) verlaufen, und wobei die elastische Einrichtung ein Paar von Kompressionsschraubenfedern (17, 18) aufweist, die um einen Stift (13, 14) des Paars gewunden und zwischen der ersten und zweiten Platte angeordnet sind.

3. Eine Halterung gemäß Anspruch 1 oder 2, bei der die Befestigungseinrichtung Einhakzähne (31, 32) für eine passende Ineingriffnahme mit dem Trageelement und Sockel (34, 35) für die Einhackzähne in einer Basis (4) des Tragebauglieds aufweist.

## Revendications

1. Porte-connecteur (1, 2, 3) pour un connecteur (10) avec réglage spatial de la position de connecteur (10), comprenant :
une première plaque (1) de support se trouvant sur un plan,
un premier connecteur (10) fixé à ladite première plaque (1), ladite première plaque (1) étant pourvue d'un moyen (5, 6) d'alignement coopérant avec un moyen (7, 8) d'alignement situé sur un premier appareil électrique (80) à connecter avec ledit premier connecteur (10) dans un sens d'introduction prédéterminé perpendiculaire au plan de ladite première plaque,
une seconde plaque (2) de support parallèle à ladite première plaque,
un premier moyen (13, 14) d'accouplement mécanique destiné à accoupler lesdites première et seconde plaques l'une avec l'autre et à permettre une quantité prédéterminée de déplacement relatif desdites première et seconde plaques dans ledit sens d'introduction prédéterminé et une variation du parallélisme desdites première et seconde plaques,
un moyen élastique (17, 18) destiné à exercer une force de séparation prédéterminée entre lesdites première et seconde plaques,
un élément (3) de support,
un second moyen (27, 28, 29, 30, 21, 22) d'accouplement mécanique destiné à accoupler ladite seconde plaque (2) avec ledit élément (3) de support, en fournissant ainsi une quantité prédéterminée de mobilité relative dans le plan de ladite seconde plaque (2), et
un moyen (31, 32) d'assemblage destiné à assembler ledit élément (3) de support avec ledit élément (4) de support, et
un raccord électrique souple (11) connecté électriquement avec ledit premier connecteur (10) pour connexion avec un second appareil électrique.

2. Porte-connecteur selon la revendication 1, dans lequel ledit moyen d'accouplement mécanique comprend deux broches (13, 14) perpendiculaires au plan desdites première et seconde plaques, fixes par rapport à ladite première plaque et traversant avec possibilité de coulissement des ouvertures (15, 16) dans ladite seconde plaque (2), et dans lequel ledit moyen élastique comprend deux ressorts hélicoïdaux (17, 18) de compression enroulés chacun autour d'une broche (13, 14) de ladite paire et interposés entre lesdites première et seconde plaques.

3. Porte-connecteur selon la revendication 1 ou la revendication 2, dans lequel ledit moyen d'assemblage comprend des dents en crochet (31, 32) pour ajustement mutuel avec ledit élément de support et des cavités (34, 35) destinées auxdites dents en crochet, situées dans une base (4) dudit élément de support.
